Europäisches Patentamt

European Patent Office

Office européen des brevets

(11) Veröffentlichungsnummer: **0 166 987**
**A1**

(12) **EUROPÄISCHE PATENTANMELDUNG**

(21) Anmeldenummer: 85106848.6

(22) Anmeldetag: 03.06.85

(51) Int. Cl.⁴: **H 02 M 1/092**
**H 03 K 17/08**

(30) Priorität: 15.06.84 DE 3422331

(43) Veröffentlichungstag der Anmeldung:
08.01.86 Patentblatt 86/2

(84) Benannte Vertragsstaaten:
AT CH DE FR GB IT LI SE

(71) Anmelder: Siemens Aktiengesellschaft
Berlin und München Wittelsbacherplatz 2
D-8000 München 2(DE)

(72) Erfinder: Thiele, Gerd, Dipl.-Ing.
Lessingstrasse 3b
D-8520 Erlangen(DE)

(54) Halbleiterschalter mit einem Leistungsthyristor.

(57) Bei dem erfindungsgemäßen Halbleiterschalter ist zwischen Anode und Gate des Leistungsthyristors (1) ein überkopfzündfester, vorzugsweise lichtzündbarer Hilfsthyristor (2) geschaltet. Um für den Überspannungsschutz des Leistungsthyristors (1) eine Anpassung der Kippspannung des Hilfsthyristors (2) an die Blockierspannung des Leistungsthyristors (1) zu vermeiden und um den Überspannungsschutz unabhängig von Streuungen der Kippspannung des Hilfsthyristors (2) zu gestalten, ist ein überkopfzündfester Leistungsthyristor (1) vorgesehen. Bei dieser Schaltungsanordnung ist weder eine Anpassung der Kippspannung des Hilfsthyristors (2) erforderlich, noch ist Die Streuung seiner Kippspannung zu berücksichtigen, da entweder der Leistungsthyristor (1) über Kopf zündet, oder durch Überkopfzünden des Hilfsthyristors (2) bei Überspannung über sein Gate eingeschaltet wird.

EP 0 166 987 A1

016898,

Siemens Aktiengesellschaft     Unser Zeichen
Berlin und München             VPA **84 P 3 2 1 8 E**

## Halbleiterschalter mit einem Leistungsthyristor

Die Erfindung betrifft einen Halbleiterschalter mit einem Leistungsthyristor, zwischen dessen Anode und Gate ein überkopfzündfester Hilfsthyristor geschaltet ist.

Ein solcher Halbleiterschalter ist aus der DE-OS 31 31 894 bekannt, wo als Hilfsthyristor ein lichtzündbarer Hilfsthyristor eingesetzt ist. Bei diesem Halbleiterschalter erfolgt die normale Zündung des Leistungsthyristors mit einem Lichtsignal, das den Hilfsthyristor zündet. Zusätzlich wird über den Hilfsthyristor eine Schutzzündung bei Überspannung ausgelöst. Damit wird mit einem Element sowohl die Schutzzündung als auch die Normalzündung durchgeführt. Voraussetzung hierfür ist, daß die Nullkippspannung des Hilfsthyristors kleiner als oder höchstens gleich der zulässigen Blockierspannung des Leistungsthyristors ist und daß die Streuung der Nullkippspannung des Hilfsthyristors möglichst klein ist, da sonst die individuelle Zündspannung des Leistungsthyristors niedriger als sein zulässiger Spitzensperrspannungswert wird und gegebenenfalls die Zahl von Leistungsthyristoren, die in Reihe zu schalten sind, erhöht werden muß.

Es besteht die Aufgabe, einen Halbleiterschalter der eingangs genannten Art so auszugestalten, daß eine Anpassung der Kippspannung des Hilfsthyristors entfällt.

Erfindungsgemäß wird diese Aufgabe dadurch gelöst, daß der Leistungsthyristor überkopfzündfest ist.

Soe 2 Bim / 08.06.1984

Bei dem erfindungsgemäßen Halbleiterschalter braucht weder die Streuung der Kippspannung des Hilfsthyristors beachtet werden, noch ist eine Anpassung der Kippspannung des Hilfsthyristors an die Blockierspannung des Leistungsthyristors erforderlich, da bei Überspannung entweder der Leistungsthyristor eine Überkopfzündung durchführt oder vermittels des gezündeten Hilfsthyristors über sein Gate eingeschaltet wird.

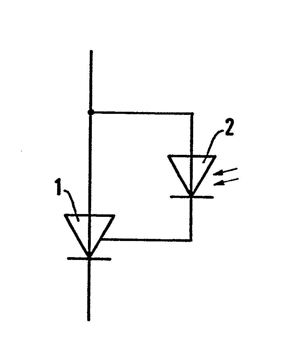

Im folgenden wird der erfindungsgemäße Halbleiterschalter beispielhaft anhand der Figur näher erläutert.

Die Figur zeigt einen überkopfzündfesten Leistungsthyristor 1, zwischen dessen Anode und dessen Gate ein überkopfzündfester, lichtzündbarer Hilfsthyristor 2 geschaltet ist. Normalerweise wird der Leistungsthyristor 1 mittels eines Lichtimpulses für den Hilfsthyristor 2 gezündet. Steht am gesperrten Leistungsthyristor 1 eine Überspannung an, so zündet entweder der Leistungsthyristor 1, da seine eigene Kippspannung überschritten ist, oder der Leistungsthyristor wird über seinen Gateanschluß gezündet, wenn die Kippspannung des lichtzündbaren Hilfsthyristors 2 überschritten ist. Eine Anpassung der Kippspannung des lichtzündbaren Hilfsthyristors 2 an die Blockierspannung des Leistungsthyristors ist praktisch nicht mehr erforderlich und auch Streuungen der Kippspannung des Hilfsthyristors 2 brauchen nicht mehr berücksichtigt zu werden.

1 Patentanspruch
1 Figur

Patentanspruch

1. Halbleiterschalter mit einem Leistungsthyristor, zwischen dessen Anode und Gate ein überkopfzündfester Hilfsthyristor geschaltet ist, d a d u r c h  g e k e n n z e i c h n e t ,  daß der Leistungsthyristor (1) überkopfzündfest ist.

**Europäisches Patentamt**

**EUROPÄISCHER RECHERCHENBERICHT**

0166987

Nummer der Anmeldung

EP 85 10 6848

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| D,A | EP-A-0 071 945 (SIEMENS) <br> * Zusammenfassung * <br><br> ----- | 1 | H 02 M 1/092 <br> H 03 K 17/08 |
|  |  |  | **RECHERCHIERTE SACHGEBIETE (Int. Cl 4)** <br><br> H 02 M <br> H 03 K <br> H 02 H |

Der vorliegende Recherchenbericht wurde für alle Patentansprüche erstellt.

| Recherchenort <br> DEN HAAG | Abschlußdatum der Recherche <br> 16-09-1985 | Prüfer <br> KERN H. |
|---|---|---|

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument

EPA Form 1503 03 82